# EUROPÄISCHE PATENTSCHRIFT

(11) **EP 4 131 383 B1**
(45) Veröffentlichungstag und Bekanntmachung des Hinweises auf die Patenterteilung: **09.04.2025**
(21) Anmeldenummer: 21189013.2
(22) Anmeldetag: 02.08.2021
(51) Int. Cl.: H01L 27/148

(54) **LADUNGSÜBERTRAGUNGSVORRICHTUNG MIT EINEM AUSBUCHTUNGSBEREICH FÜR TAKTFREQUENZEN AB 100 MHZ**
CHARGE TRANSFER DEVICE WITH A PROJECTION AREA FOR CLOCK FREQUENCIES ABOVE 100 MHZ
DISPOSITIF DE TRANSFERT DE CHARGE DOTÉ D'UNE ZONE DE COURBURE POUR FRÉQUENCES D'HORLOGE À PARTIR DE 100 MHZ

(43) Veröffentlichungstag der Anmeldung: 08.02.2023
(73) Patentinhaber: Espros Photonics AG, 7320 Sargans (CH)
(72) Erfinder: DE COI, Beat, 7304 Maienfeld (CH); YU, Chongqi, 7310 Bad Ragaz (CH)
(74) Vertreter: Otten, Roth, Dobler & Partner mbB Patentanwälte

(56) Entgegenhaltungen:
- GB-A- 2 551 108
- US-A- 5 237 191
- US-A1- 2004 259 293
- US-A1- 2009 075 419

## Beschreibung

Die Erfindung betrifft eine Halbleiterstruktur mit einem Ladungsübertragungskanal für Taktfrequenzen im Bereich ab 100 MHz, vorzugsweise ab 250 MHz, besonders bevorzugt bis 400 MHz.

Bei Taktfrequenzen über 100 MHz, speziell über 250 MHz und insbesondere bis 400 MHz können vermehrt Verluste beim Transport der Ladungsträger durch einen Ladungsübertragungskanal auftreten. US 2009/075419 A1 offenbart eine CCD mit zwei Ladungsträgerkanälen, die ineinander einmünden sowie eine entsprechende Ausbuchtung des Ladungsträgerkanals.

Es ist Aufgabe der Erfindung, eine verbesserte Ladungsübertragung bei Taktfrequenzen über 100 MHz, vorzugsweise ab 250 MHz, besonders bevorzugt bis 400 MHz bereitzustellen.

Die Aufgabe wird, ausgehend von einer Halbleiterstruktur der eingangs genannten Art, durch die kennzeichnenden Merkmale des Anspruchs 1 gelöst. Durch die in den Unteransprüchen genannten Maßnahmen sind vorteilhafte Ausführungen und Weiterbildungen der Erfindung möglich.

Die erfindungsgemäße Ladungsübertragungsvorrichtung verwendet unter anderem einen Ladungsträgerkanal. Ein Ladungsübertragungskanal kann eine Überlappung der möglichen elektrostatischen Wirkung von aneinander angrenzenden Gattern mit einer Leitungsschicht in einem Halbleiter sein. Der Ladungsübertragungskanal kann so das Schnittvolumen aus der Projektion der elektrostatischen Wirkung der Gatter auf die Volumenstruktur der Leitungsschicht sein.

Die Leitungsschicht, in welcher der Ladungsträgertransport bzw. die Ladungsträgerübertragung stattfindet, kann in einem Halbleitersubstrat liegen und unterschiedlich zum umgebenden Halbleitersubstrat dotiert sein, sodass sich Ladungsträger in der Leitungsschicht bewegen können und nicht in das umgebende Halbleitersubstrat austreten. Eine Leitungsschicht kann vergraben sein oder an der Oberfläche des Halbleitersubstrats liegen.

Die Gatter können Elektroden sein, welche entlang der Leitungsschicht angeordnet und durch eine dünne, nichtleitende Trennschicht von der Leitungsschicht getrennt sind, sodass sich eine Potentialänderung der Gatter als Änderung des elektrischen Feldes im überlappend zugeordneten Bereich der Leitungsschicht auswirkt. Die Gatter können durch eine dünne Trennschicht isoliert auf dem Halbleitersubstrat liegen.

Ladungsträger können Elektronen oder Löcher sein.

Durch entsprechende Potentialänderungen angrenzender Gatter können Ladungsträger im Ladungsübertragungskanal transportiert werden, sodass der Ladungsübertragungskanal als Leitungskanal für einen gerichteten Fluss von Ladungsträger wirken kann. Die Potentialänderung folgt im Allgemeinen einer Taktfrequenz. Die Potentialänderungen können dabei einer Taktfrequenz folgen. Die Taktfrequenz bestimmt die Geschwindigkeit des Ladungstransports und damit die zeitliche Auflösung und Leistungsfähigkeit umgebender oder angeschlossener Systeme wie etwa Sensoren oder Recheneinheiten.

Grenzen, Form und Verlauf der Gatter, der Leitungsschicht und des Ladungsübertragungskanals sind stets in Draufsicht von den Gattern her in Richtung der Leitungsschicht angegeben, soweit im Einzelfall nicht anders genannt ist. Der Verlauf des Ladungsübertragungskanals und räumliche Relationen sind stets in Richtung des Ladungsträgerflusses im Ladungsübertragungskanal angegeben, soweit im Einzelfall nicht anders genannt ist.

Falls die Breite des Verlaufs der aneinandergereihten Gatter schmaler ist als die Breite des Verlaufs der zugeordneten Leitungsschicht, dann sind die Grenzen der Breite des Verlaufs des Ladungsübertragungskanals durch die Grenzen des Verlaufs der Breite der aneinandergereihten Gatter gegeben. Falls die Breite des Verlaufs der aneinandergereihten Gatter breiter ist als die Breite des Verlaufs der zugeordneten Leitungsschicht, dann sind die Grenzen der Breite des Verlaufs des Ladungsübertragungskanals durch die Grenzen des Verlaufs der Breite der zugeordneten Leitungsschicht gegeben.

Im Zusammenhang mit der Erfindung wurde erkannt, dass bei höheren Taktfrequenzen ab 100 MHz oder 250 MHz oftmals ein Teil der unter einem Gatter befindlichen Ladungsträger bei entsprechender Potentialänderung nicht wie gewünscht zum nächsten Gatter übertritt; in vorteilhafter Weise kann dieser Effekt durch die erfindungsgemäße Ladungsübertragungsvorrichtung reduziert bzw. vermieden werden.

Die erfindungsgemäße Ladungsübertragungsvorrichtung ist eine Ladungsübertragungsvorrichtung entsprechend Anspruch 1 mit einem Ladungsübertragungskanal in einem Halbleitersubstrat mit einer dotierten Leitungsschicht zur beweglichen Aufnahme der Ladungsträger mit einer Abfolge von mindestens zwei elektrisch getrennten Gattern welche benachbart aufeinander folgen zur Verschiebung der Ladungsträger in der Leitungsschicht in eine Flussrichtung wobei der Ladungsübertragungskanal durch Überlappung der möglichen elektrostatischen Wirkung der Gatter mit der Leitungsschicht ausgebildet ist und mit einem Taktgeber mit einer Taktfrequenz von über 100 MHz, insbesondere von über 150 MHz, über 200 MHz oder über 250 MHz und insbesondere bis 300 MHz oder 400 MHz welcher die Gatter mit Potentialänderungen in Taktfrequenz beaufschlagt zum Transport von Ladungsträgern in der Taktfrequenz von benachbarten Bereichen der Überlappung von benachbarten Gattern mit der Leitungsschicht, was dem Transport über eine CCD-Struktur entspricht, wobei der Ladungsübertragungskanal und insbesondere ein Gatter oder die Abfolge von zwei angrenzender Gatter einen Bereich einer Ausbuchtung aufweist in welchem der Querschnitt in Flussrichtung zuerst zunimmt (insbesondere um mehr als 20%, 40%, 80% oder 100%) und dann wieder abnimmt (insbesondere um mehr als 20%, 40%, oder 80%) und welcher über den Bereich von ein oder zwei aneinandergrenzenden Gattern erstreckend angeordnet ist und einen Bereich einer Verengung aufweist in welchem der Querschnitt in Flussrichtung abnimmt, und insbesondere kontinuierlich, insbesondere konstant abnimmt und mindestens im Bereich des Gates vor dem Bereich der Ausbuchung oder in den Bereichen des Gates vor der Ausbuchtung und des angrenzenden Gates der Ausbuchtung angeordnet ist.

Dieser erfindungsgemäße Ladungsübertragungskanal kann den Vorteil ausbilden, dass Ladungsträger mit weniger Widerstand und/oder weniger Verlusten fliessen können.

Vorzugsweise ist zur Eingrenzung der Verluste der Bereich der Verengung in einem Abstand kleiner als die maximale Breite des Bereichs der Ausbuchtung vor der Ausbuchtung angeordnet, insbesondere in einem Abstand kleiner ½, ¼, oder 1/8 der Breite der Ausbuchtung, und grenzt insbesondere unmittelbar vor der Ausbuchtung an die Ausbuchtung an.

Vorzugsweise ist der Bereich der Verengung in Flussrichtung abgeschrägt ausgeführt und insbesondere trichterförmig ausgeführt, um einen möglichst kontinuierlichen Fluss zu erreichen.

Zudem kann der Widerstand durch folgende Maßnahmen jeweils reduziert werden: Vorzugsweise weist der Bereich der Ausbuchtung eine Länge von kleiner ½, insbesondere kleiner ¼, insbesondere kleiner 1/8 der maximalen Breite auf.

Vorzugsweise weist der Bereich der Ausbuchtung eine maximale Breite auf, deren Verhältnis zur Breite des Leitungskanals vor der Verengung oder nach der Ausbuchtung mehr als um 110%, 120%, 130%, 140%, oder 150% beträgt und/oder weniger als 200%, 180%, oder 160% beträgt.

Die Verengung reduziert den Rücklauf (Spill Back) oder der Flusswiderstand oder der Verlust der Ladungsträger in der Ausbuchtung.

### Überblick über die Zeichnungen:

Ausführungsbeispiele der Erfindung sind in den Zeichnungen dargestellt und werden im Folgenden näher erläutert. Gleiche Bezugszeichen in den einzelnen Figuren bezeichnen dabei einander entsprechende Elemente. Es zeigen:
Fig. 1 Ladungsübertragungskanal in Seitenansicht entlang Flussrichtung
Fig. 2 Ladungsübertragungskanal in Seitenansicht senkrecht Flussrichtung
Fig. 3 Ladungsübertragungskanal mit Verengung in Draufsich entsprechend eines Beispiels, das nicht Teil der beanspruchten Erfindung ist.
Fig. 4 Ladungsübertragungskanal mit Ausbuchtung und Verengung in Draufsicht entsprechend eines Ausführungsbeispiels, das Teil der beanspruchten Erfindung ist.

### Detaillierte Beschreibung der Zeichnungen:

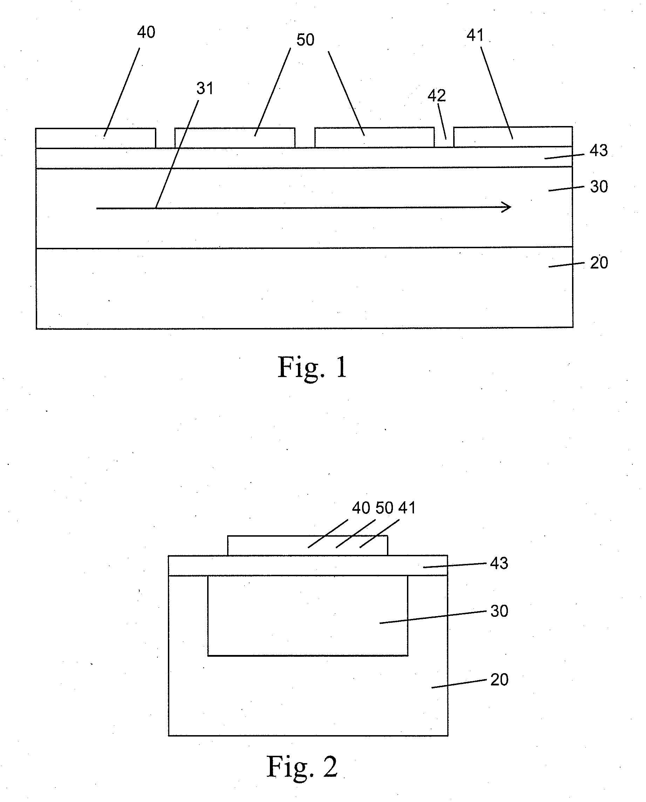

Fig. 1 zeigt einen Ladungsübertragungskanal 10 in Seitenansicht entlang der Flussrichtung 31 der Ladungsträger der folgenden Figuren. Der Aufbau ist analog CCD Technologie. Das umgebende Halbleitersubstrat 20 ist p+ dotiert. Im Halbleitersubstrat 20 ist eine vergrabene Leitungsschicht 30 angeordnet. Die Leitungsschicht ist schwach n- dotiert. Dies hat zur Folge, dass in der Leitungsschicht Elektronen als Ladungsträger frei beweglich sind und nicht in das Halbleitersubstrat eindringen. Auf der Leitungsschicht ist eine Isolationsschicht 43 aufgebracht und darauf sind Gatter 40, 41, 50 aus Metall angeordnet. Die Gatter sind durch Zwischenräume elektrisch voneinander getrennt. Der nicht dargestellte Taktgeber beaufschlagt die benachbarten Gatter wechselweise mit einem positiven Potential in einer Taktfrequenz von 250 MHz, sodass Leitungselektronen in der Leitungsschicht von einem Gatter zum nächsten angezogen und so in Flussrichtung verschoben werden. Die Taktfrequenz könnte auch lediglich über 100 MHz, über 150 MHz oder über 200 MHz betragen. Im Allgemeinen ist die Taktfrequenz nicht höher als 300 MHz. Die Leitungselektronen können beispielsweise photoinduzierte Elektronen aus einem an den Leitungskanal angeschlossenen Bildsensor sein.

Das Halbleitersubstrat 20 ist p+ dotiert und die Leitungsschicht 30 ist n- dotiert. Die Isolationsschicht 43 ist aus SiO2 und die Gatter sind aus Metall gebildet.

Fig. 2 zeigt den Ladungsübertragungskanal in Seitenansicht senkrecht zur Flussrichtung der Ladungsträger der folgenden Figuren. Die Leitungsschicht 30 ist vergraben, sodass im sie von oben und der Seite vom Halbleitersubstrat 20 umfasst ist. Halbleitersubstrat 20 und Leitungsschicht 30 sind nach oben mit einer Isolationsschicht versehen. Die Gatter 40, 41, 50 sind im Bereich über der Leitungsschicht 30 auf der Isolationsschicht 43 angeordnet. Die Gatter sind entlang der Flussrichtung in der Breitenausdehnung schmäler als die Leitungsschicht ausgeführt.

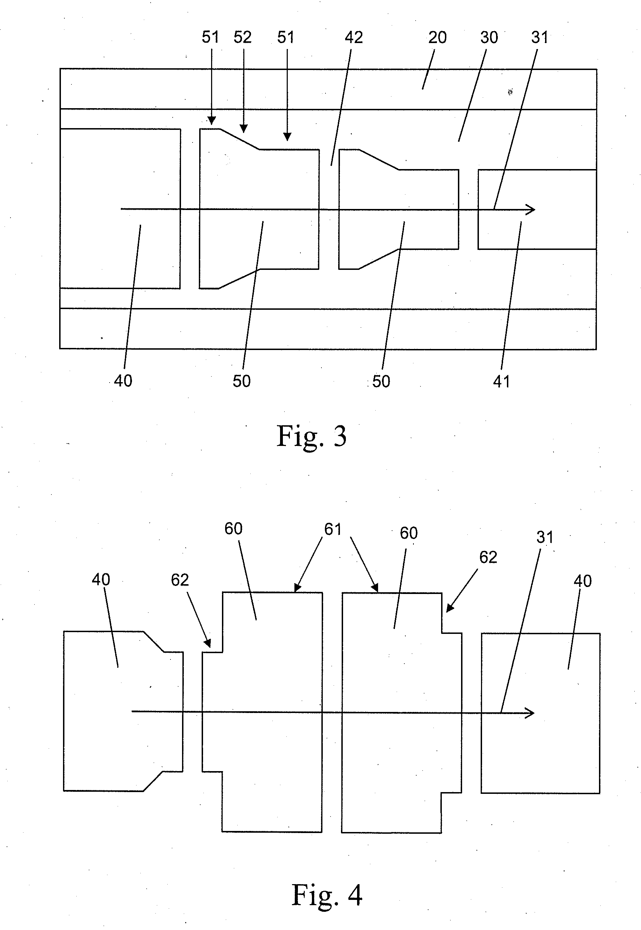

Fig. 3 zeigt einen Ladungsübertragungskanal in Draufsicht. Im Halbleitersubstrat 20 ist die Leitungsschicht 30 eingebettet. Die darüber liegende Isolationsschicht ist nicht gezeigt. Über dem Bereich der Leitungsschicht 30, durch die nicht gezeigte Isolationsschicht getrennt, sind die Gatter 40, 50, 41 in Flussrichtung 31 der Elektronen und mit Abständen 42 elektrisch getrennt angeordnet. Insgesamt zeigen die Gatter in Flussrichtung eine Verengung des Querschnitts. Das erste Gatter 40 weist deinen breiten Querschnitt auf, während das letzte Gatter 41 einen vergleichsweise schmäleren Querschnitt aufweist. Die beiden Gatter 50 weisen einen sich in Flussrichtung 31 verengenden Querschnitt auf. Das sich verengende Gatter 50 weist in Flussrichtung 31 zunächst einen breiten Bereich mit konstantem Querschnitt ohne Verengung 51 auf, dann einen im Querschnitt schmäler werdenden Bereich mit Verengung 52 und darauf einen schmäleren Bereich mit wieder konstantem Querschnitt ohne Verengung 51. Das Gatter 50 weist dabei Bereiche mit konstantem Querschnitt am Übergang zu den benachbarten Gattern auf. Der entgegen der Flussrichtung angeordnete Bereich mit konstantem Querschnitt ohne Verengung ist kürzer als der in Flussrichtung angeordnete Bereich mit konstantem Querschnitt ohne Verengung. Dadurch ist der schmäler werdende Bereich mit Verengung 52 aus der Mitte des Gatters 50 entgegen der Richtung der Flussrichtung verschoben angeordnet. Der schmäler werdende Bereich mit Verengung 52 ist beidseitig abgeschrägt ausgeführt, sodass er eine trichterförmige Form aufweist. Durch die so gezeigte Ausführung einer Verengung kann der Rücklauf (Spill Back) und/oder der Flusswiderstand und/oder die Verluste der Ladungsträger in Flussrichtung minimiert werden.

Fig. 4 zeigt die Gatter eines Ladungsübertragungskanals in Draufsicht. Die maximale Breite der in Flussrichtung zu Beginn und am Ende der gezeigten Gatterabfolge liegenden Gatter 40 bildet die typische Breite des Querschnitts des Leitungsübertragungskanals. Demgegenüber weisen die zwei Gatter 60 einen zusammenhängenden Bereich einer Ausbuchtung 61 auf bei welchem der Querschnitt im Vergleich zur typischen Breite um die Breite 62 etwa 25 % vergrössert ist. Unmittelbar der Ausbuchtung weist das erste Gatter 60 mit der Ausbuchtung eine Verengung 62 auf, bei welcher der Querschnitt des Ladungsübertragungskanals im Vergleich zur typischen Breite schmäler ist. Dadurch ist der Eintritt in die Ausbuchtung schmaler als der Austritt aus der Ausbuchtung. Die Verengung 62 ist bereits beim in Flussrichtung vorhergehenden Gatter 40 ausgeführt, welches durch einen richterförmigen Bereich den Querschnitt vom typischen Querschnitt auf den reduzierten Querschnitt der Verengung verringert. Durch die so gezeigte Ausführung einer Ausbuchtung kann der Rücklauf (Spill Back) und/oder der Flusswiderstand und/oder die Verluste der Ladungsträger in Flussrichtung minimiert werden.

### Bezugszeichenliste:

- 10: Ladungsübertragungskanal

- 20: Halbleitersubstrat

- 30: Leitungsschicht
- 31: Flussrichtung

- 40: Gatter, breit
- 41: Gatter, schmal
- 42: Isolierender Abstand zwischen den Gattern
- 43: Isolationsschicht

- 50: Gatter mit Verengung
- 51: Bereich ohne Verengung
- 52: Bereich mit Verengung

- 60: Gatter mit Ausbuchtung
- 61: Bereich mit Ausbuchtung
- 62: Breite der Ausbuchtung
- 62: Verengung

## Patentansprüche

1. Ladungsübertragungsvorrichtung
- mit einem Ladungsübertragungskanal (10) in einem Halbleitersubstrat (20)
- mit einer dotierten Leitungsschicht (30)
- zur beweglichen Aufnahme der Ladungsträger
- mit einer Abfolge von mindestens zwei elektrisch getrennten Gattern
- welche benachbart aufeinander folgen
- zur Verschiebung der Ladungsträger in der Leitungsschicht
- in eine Flussrichtung (31)
- wobei der Ladungsübertragungskanal durch Überlappung der möglichen elektrostatischen Wirkung der Gatter mit der Leitungsschicht ausgebildet ist
- und mit einem Taktgeber
- mit einer Taktfrequenz von über 100 MHz, bevorzugt von über 150 MHz, über 200 MHz oder über 250 MHz und besonders bevorzugt bis 300 MHz oder 400 MHz
- welcher die Gatter mit Potentialänderungen in Taktfrequenz beaufschlagt
- zum Transport von Ladungsträgern in der Taktfrequenz von benachbarten Bereichen der Überlappung von benachbarten Gattern mit der Leitungsschicht,
wobei
- der Ladungsübertragungskanal
- und die Abfolge von zwei angrenzenden Gattern (60)
- einen Bereich einer Ausbuchtung (61) aufweisen
- in welchem der Querschnitt in Flussrichtung zuerst zunimmt, bevorzugt um mehr als 20%, 40%, 80% oder 100%, und dann wieder abnimmt, bevorzugt um mehr als 20%, 40%, oder 80%, und
- welcher über den Bereich der zwei aneinandergrenzenden Gattern erstreckend angeordnet ist,
wobei die maximale Breite der in Flussrichtung zu Beginn und am Ende der Gatterabfolge liegenden Gatter (40) die typische Breite des Querschnitts des Leitungsübertragungskanals bildet,
**dadurch gekennzeichnet, dass** der Ladungsübertragungskanal und die Abfolge von zwei angrenzenden Gattern einen Bereich einer Verengung (62) aufweisen,
- in welchem der Querschnitt in Flussrichtung abnimmt, und bevorzugt kontinuierlich, besonders bevorzugt konstant abnimmt und
- mindestens im Bereich des entsprechenden Gatters (40) vor dem Bereich der Ausbuchtung oder in den Bereichen des entsprechenden Gatters (40) vor der Ausbuchtung und des angrenzenden Gatters (60) der Ausbuchtung angeordnet ist,
*wobei die zwei angrenzenden Gatter (60) einen zusammenhängenden Bereich der Ausbuchtung (61) aufweisen, bei welchem der Querschnitt im Vergleich zur typischen Breite um etwa 25% vergrößert ist, und*
*wobei unmittelbar in Flussrichtung vor der Ausbuchtung das erste Gatter mit der Ausbuchtung die Verengung (62) aufweist, bei welcher der Querschnitt des Ladungsträgerkanals im Vergleich zur typischen Breite schmäler* ist, wodurch in Flussrichtung die Breite des Ladungsübertragungskanals senkrecht zur Flussrichtung beim Eintritt in die Ausbuchtung schmäler ist als beim Austritt aus der Ausbuchtung.

2. Ladungsübertragungsvorrichtung nach Anspruch 1,
**dadurch gekennzeichnet, dass**
- der Bereich der Verengung
- in einem Abstand kleiner als die maximale Breite des Bereichs der Ausbuchtung vor der Ausbuchtung angeordnet ist, bevorzugt in einem Abstand kleiner ½, ¼, oder 1/8 der Breite der Ausbuchtung, und
- bevorzugt unmittelbar vor der Ausbuchtung an die Ausbuchtung angrenzt.

3. Ladungsübertragungsvorrichtung nach einem der vorhergehenden Ansprüche, **dadurch gekennzeichnet, dass**
- der Bereich der Ausbuchtung
- eine Länge in Flussrichtung von kleiner ½, bevorzugt kleiner ¼, besonders bevorzugt kleiner 1/8 der maximalen Breite senkrecht zur Flussrichtung aufweist.

4. Ladungsübertragungsvorrichtung nach einem der vorhergehenden Ansprüche, **dadurch gekennzeichnet, dass**
- der Bereich der Ausbuchtung
- eine maximale Breite senkrecht zur Flussrichtung aufweist, deren Verhältnis zur Breite des Leitungskanals vor der Verengung oder nach der Ausbuchtung
- mehr als um 110%, 120%, 130%, 140%, oder 150% beträgt und/oder
- weniger als 200%, 180%, oder 160% beträgt.

5. Ladungsübertragungsvorrichtung nach einem der vorhergehenden Ansprüche, **dadurch gekennzeichnet, dass**
- das Halbleitersubstrat p+ dotiert ist und/oder
- die Leitungsschicht schwach n- dotiert ist und/oder
- die Gatter aus Metall gebildet sind und/oder
- die zwischen den Gattern und der Leitungsschicht eine nichtleitende Schicht angeordnet ist und/oder
- die Gatter untereinander elektrisch isoliert getrennt sind.

## Claims

1. Charge transfer device
- having a charge transfer channel: (10) in a semiconductor substrate (20)
- having a doped conduction layer (30)
- for movably accepting the charge carriers,
- having a sequence of at least two electrically isolated gates
- which adjacently succeed one another
- for transferring the charge carriers in the conduction layer
- in a flow direction (31),
- wherein the charge transfer channel is formed by overlap of the possible electrostatic effect of the gates with the conduction layer,
- and having a clock generator
- having a clock frequency of more than 100 MHz, preferably of more than 150 MHz, more than 200 MHz or more than 250 MHz and particularly preferably up to 300 MHz or 400 MHz,
- which clock generator applies changes in potential at the clock frequency to the gates,
- for transporting charge carriers at the clock frequency from adjacent regions of the overlap between adjacent gates and the conduction layer,
wherein
- the charge transfer channel
- and the sequence of two adjoining gates (60)
- have a region of a protuberance (61)
- in which the cross section in the flow direction first increases, preferably by more than 20%, 40%, 80% or 100%, and then decreases again, preferably by more than 20%, 40%, or 80%, and
- which is arranged in a manner extending over the region of the two mutually adjoining gates, wherein the maximum width of the gates (40) situated at the beginning and end of the gate sequence in the flow direction forms the typical width of the cross section of the conduction transfer channel, **characterized in that** the charge transfer channel and the sequence of two adjoining gates have a region of a constriction (62)
- in which the cross section decreases in the flow direction, and preferably decreases continuously, particularly preferably in a constant fashion, and
- is arranged at least in the region of the corresponding gate (40) upstream of the region of the protuberance or in the regions of the corresponding gate (40) upstream of the protuberance and the adjoining gate (60) of the protuberance,
*wherein the two adjoining gates (60) have a continuous region of the protuberance (61), in the case of which the cross section is enlarged by approximately 25% in comparison with the typical width, and*
*wherein, directly upstream of the protuberance in the flow direction, the first gate having the protuberance has the constriction (62), in the case of which the cross section of the charge transfer channel is narrower in comparison with the typical width,* as a result of which, in the flow direction, the width of the charge transfer channel perpendicular to the flow direction is narrower at the entry into the protuberance than at the exit from the protuberance.

2. Charge transfer device according to Claim 1, **characterized in that**
- the region of the constriction
- is arranged upstream of the protuberance at a distance of less than the maximum width of the region of the protuberance, preferably at a distance of less than ½, ¼, or 1/8 of the width of the protuberance, and
- preferably adjoins the protuberance directly upstream of the protuberance.

3. Charge transfer device according to either one of the preceding claims,
**characterized in that**
- the region of the protuberance
- has a length in the flow direction of less than ½, preferably less than ¼, particularly preferably less than 1/8, of the maximum width perpendicular to the flow direction.

4. Charge transfer device according to any one of the preceding claims,
**characterized in that**
- the region of the protuberance
- has a maximum width perpendicular to the flow direction whose ratio to the width of the conduction channel upstream of the constriction or downstream of the protuberance
- is more than 110%, 120%, 130%, 140%, or 150%, and/or
- is less than 200%, 180%, or 160%.

5. Charge transfer device according to any one of the preceding claims,
**characterized in that**
- the semiconductor substrate is p+ doped and/or
- the conduction layer is weakly n- doped and/or
- the gates are formed from metal and/or
- a nonconducting layer is arranged between the gates and the conduction layer and/or
- the gates are separated in a manner electrically insulated from one another.

## Revendications

1. Dispositif de transfert de charge, comprenant
- un canal de transfert de charge : (10) dans un substrat semi-conducteur (20)
- une couche conductrice dopée (30)
- pour recevoir les porteurs de charge de manière mobile,
- une série d'au moins deux grilles électriquement isolées
- qui se suivent en étant voisines
- pour décaler les porteurs de charge dans la couche conductrice
- dans une direction de flux (31),
- dans lequel le canal de transfert de charge est réalisé par le chevauchement de l'effet électrostatique possible des grilles avec la couche conductrice
- et un générateur d'horloge
- ayant une fréquence d'horloge de plus de 100 MHz, de préférence de plus de 150 MHz, de plus de 200 MHz ou de plus de 250 MHz, et de manière particulièrement préférée jusqu'à 300 MHz ou 400 MHz,
- qui soumet les grilles à des changements de potentiel à la fréquence d'horloge
pour le transport de porteurs de charge à la fréquence d'horloge de zones voisines du chevauchement de grilles voisines au moyen de la couche conductrice,
dans lequel
- le canal de transfert de charge
- et la série de deux grilles adjacentes (60)
- présentent une zone de renflement (61)
- dans laquelle la section transversale dans la direction de flux augmente d'abord, de préférence de plus de 20 %, 40 %, 80 % ou 100 %, et diminue ensuite à nouveau, de préférence de plus de 20 %, 40 % ou 80 %, et
- qui est agencée de manière à s'étendre sur la zone des deux grilles adjacentes, dans lequel la largeur maximale des grilles (40) situées au début et à la fin de la série de grilles dans la direction de flux constituent la largeur typique de la section transversale du canal de transfert de conduction, **caractérisé en ce que** le canal de transfert de charge et la série de deux grilles adjacentes présentent une zone de rétrécissement (62),
- dans laquelle la section transversale diminue dans la direction de flux, et de préférence de manière continue, et de manière particulièrement préférée de manière constante et
- est disposée au moins dans la zone de la grille (40) correspondante avant la zone de renflement ou dans les zones de la grille (40) correspondante avant le renflement et de la grille adjacente (60) du renflement,
*dans lequel les deux grilles adjacentes (60) présentent une zone contiguë du renflement (61) dont la section transversale est augmentée d'environ 25% par rapport à la largeur typique, et*
*dans lequel, immédiatement avant le renflement dans la direction* de *flux, la première grille comprenant le renflement présente le rétrécissement (62), pour lequel la section transversale du canal de transfert de charge est plus étroite par comparaison à la largeur typique,* de sorte que, dans la direction de flux, la largeur du canal de transfert de charge perpendiculairement à la direction de flux est plus étroite à l'entrée dans le renflement qu'à la sortie du renflement.

2. Dispositif de transfert de charge selon la revendication 1,
**caractérisé en ce que**
- la zone du rétrécissement
- est disposée à une distance inférieure à la largeur maximale de la zone du renflement avant le renflement, de préférence à une distance inférieure à ½, ¼, ou 1/8 de la largeur du renflement, et
- de préférence immédiatement avant le renflement, est adjacente au renflement.

3. Dispositif de transfert de charge selon l'une quelconque des revendications précédentes,
**caractérisé en ce que**
- la zone du renflement
- présente une longueur, dans la direction de flux, inférieure à ½, de préférence inférieure à ¼, de manière particulièrement préférée inférieure à 1/8 de la largeur maximale perpendiculairement à la direction de flux.

4. Dispositif de transfert de charge selon l'une quelconque des revendications précédentes,
**caractérisé en ce que**
- la zone du renflement
- présente une largeur maximale, perpendiculairement à la direction de flux, dont le rapport à la largeur du canal de conduction avant le rétrécissement ou après le renflement
- est supérieur à 110%, 120%, 130%, 140%, ou 150%, et/ou
- est inférieur à 200%, 180% ou 160%.

5. Dispositif de transfert de charge selon l'une quelconque des revendications précédentes,
**caractérisé en ce que**
- le substrat semi-conducteur est dopé p+, et/ou
- la couche conductrice est faiblement dopée n-, et/ou
- les grilles sont formées de métal, et/ou
- la couche non conductrice est disposée entre les grilles et la couche conductrice et/ou
- les grilles sont électriquement isolées les unes des autres.
